# EUROPEAN PATENT SPECIFICATION

(11) **EP 4 200 981 B1**
(45) Date of publication and mention of the grant of the patent: **06.05.2026**
(21) Application number: 20772260.4
(22) Date of filing: 14.09.2020
(51) Int. Cl.: H03H 9/02, H03H 9/17, H03H 9/56, H03H 3/04

(54) **SOLIDLY MOUNTED BULK ACOUSTIC WAVE RESONATOR WITH FREQUENCY TUNING BY MASS LOADING IN ACOUSTIC REFLECTOR AND METHOD OF MANUFACTURING THEREOF**
FEST MONTIERTER VOLUMENSCHALLWELLENRESONATOR MIT FREQUENZABSTIMMUNG DURCH MASSENBELASTUNG IN EINEM AKUSTISCHEN REFLEKTOR UND HERSTELLUNGSVERFAHREN DAFÜR
RÉSONATEUR À ONDES ACOUSTIQUES DE VOLUME À MONTAGE SOLIDE À ACCORD DE FRÉQUENCE PAR CHARGEMENT DE MASSE DANS UN RÉFLECTEUR ACOUSTIQUE ET SON PROCÉDÉ DE FABRICATION

(43) Date of publication of application: 28.06.2023
(73) Proprietor: Huawei Technologies Co., Ltd., Shenzhen, Guangdong 518129 (CN)
(72) Inventor: ERBES, Andreja, 80992 Munich (DE)
(74) Representative: Goddar, Heinz J.
(86) International application number: PCT/EP2020/075628
(87) International publication number: WO 2022/053161

(56) References cited:
- WO-A1-2011/105313
- JP-A- 2007 208 845
- US-A1- 2008 290 969
- US-A1- 2013 038 408
- US-A1- 2017 272 053

## Description

### TECHNICAL FIELD

The present disclosure relates generally to the field of semiconductor technologies; and more specifically, to resonators, such as Bulk Acoustic Wave (BAW) resonators. Further, the present disclosure relates to integrated circuit packages comprising a plurality of BAW resonators. Furthermore, the present disclosure relates to a method of manufacturing BAW resonators.

### BACKGROUND

Acoustic wave devices, such as Micro-mechanical (MEMS) resonators, are key components used in modern electronic circuits as building blocks of front-end modules (FEM) due to their exceptional mechanical and acoustic quality, and considerably lower energy losses relative to their purely electrical counterparts (e.g. capacitors, inductors, etc.). For example, acoustic wave devices are used as filters to improve reception and transmission of signals in mobile phones and Wi-Fi receivers. There are two main categories of acoustic wave devices that are currently used by the industry to produce micro-mechanical resonators (filters). The first category of acoustic wave devices are based on surface traveling waves or Surface Acoustic Wave (SAW) resonators. These are traditionally fabricated on low loss piezoelectric material, and operated by coupling an external electric-field to the acoustic fields, creating a propagation of electro-acoustic modes into the piezoelectric material. The second category of acoustic wave devices include Bulk Acoustic Wave (BAW) resonators which use the external electric field to trigger bulk waves in the piezoelectric material. Whereas the SAW resonators tend to localize the acoustic energy into surface of the piezoelectric material, the BAW resonators tend to produce waves in the whole bulk of the piezoelectric material.

BAW resonators have been widely adapted to be used in high-frequency, communication applications, as they are usually quite compatible with state of the art micro-fabrication techniques which enables their use in a high yield, high volume and integration schemes for wireless chipset products. BAW resonators include thin film bulk acoustic resonators (FBARs), which include resonator stacks formed over a substrate cavity, and solidly mounted resonators (SMRs), which include resonator stacks formed over an acoustic reflector (e.g., Bragg mirror). Traditionally, the BAW resonator comprises a piezoelectric layer, and the thickness of the piezoelectric layer generally determines operating frequency of the BAW resonator. For instance, in case of SMR-BAW resonators operating in longitudinal modes, the operating frequency is mostly defined by the core resonator thickness of the piezoelectric material. If further frequencies are required on one same die, it is necessary to employ distinct mass loading elements, which are local variations in the electrode thickness and /or additional deposited materials (e.g., dielectrics) for a given resonator. Generally, the mass loading elements are deposited either over a top electrode, or below a bottom electrode in a Bragg layer structure.

It is to be noted that in case of multiple frequencies are required on one same die, the actual thickness variation of the different layers due to non-perfect manufacturing processes can in some cases be significantly larger than the fine thickness difference required to tune the operating frequency of different micro-resonators. In other words, it is challenging to implement a great number of frequency elements on the same die replicated across a full wafer, and thus it makes it more difficult in terms of actual processing to achieve many distinct operating frequencies. To mitigate this, additional highly controlled deposition steps are mandatory (i.e., require extremely high precision in the thickness deposition), but that increases manufacturing complexity, putting a trade-off between performance gains/ process cost. Further, it is to be considered that when mass loading elements are deposited below the bottom electrode in the Bragg layer structure, there is a need to ensure correct planarization of the subsequent deposition of thin-films.

Therefore, in light of the foregoing discussion, there exists a need to overcome the aforementioned drawbacks associated with conventional acoustic wave devices, and particularly BAW resonators, for facilitating the use of multiple frequencies all within one same die.

US 2013/038408 A1 discloses a bulk acoustic wave (BAW) resonator device that includes an acoustic reflector formed over a substrate and a resonator stack formed over the acoustic reflector. The acoustic reflector includes multiple acoustic impedance layers. The resonator stack includes a first electrode formed over the acoustic reflector, a piezoelectric layer formed over the first electrode, and a second electrode formed over the piezoelectric layer. A bridge is formed within one of the acoustic reflector and the resonator stack.

US 2017/272053 A1 discloses a BAW resonator with reduced heat build-up. The heat build-up is reduced by a thermal bridge, which dissipates heat from the electro-acoustically active region to a support substrate, without impairing the acoustics of the resonator.

JP 2007 208845 A discloses a piezoelectric resonator capable of attenuating an unnecessary vibration mode laterally propagated in a piezoelectric film, an upper electrode, a lower electrode, and a resonator holding member. The piezoelectric resonator has a piezoelectric film and a resonator main body section including the upper electrode and lower electrode formed opposite each other across the piezoelectric film. The resonator main body section has a resonance region where the upper electrode and lower electrode are both formed and a sound reflection region which excludes the resonance region of the resonator main body section and where projection and recess shapes which are periodically arranged are formed.

WO 2011/105313 A1 discloses, in order to minimize the degradation in resonance characteristics, an acoustic wave device with a substrate, a piezoelectric thin film disposed on the substrate, a bottom electrode and a top electrode sandwiching at least a portion of the piezoelectric thin film, a resonance region in which the piezoelectric thin film is sandwiched and the bottom electrode and the top electrode are facing one another, a first mass loading film equipped with multiple island patterns in the resonance region, and a second mass loading region equipped with multiple opening patterns disposed in positions corresponding respectively to the multiple island patterns in the resonance region.

### SUMMARY

The present disclosure seeks to provide a bulk acoustic wave (BAW) resonator, an integrated circuit package comprising a plurality of BAW resonators and a method of manufacturing a BAW resonator. An aim of the present disclosure is to provide a solution that overcomes at least partially the problems encountered in prior art, and provides improved devices and methods of that are able to efficiently and reliably generate resonant frequencies. The present disclosure seeks to provide a solution to the existing problem of defining multiple operating frequencies for the BAW resonators. The present disclosure provides a novel methodology to lithographically define the operating frequency of surface-mounted resonators / bulk acoustic resonators (SMR-BAW).

The object of the present disclosure is achieved by the solutions provided in the enclosed independent claims. Advantageous implementations of the present disclosure are further defined in the dependent claims.

In an aspect, the present disclosure provides a bulk acoustic wave (BAW) resonator on a substrate. The bulk acoustic wave resonator comprises a piezoelectric element, a bottom electrode on a first face of the piezoelectric element and a top electrode on a second face of the piezoelectric element facing away from the first face. The BAW resonator further comprises a reflective element between the bottom electrode and the substrate. The reflective element comprises at least a first layer of a first material having a first acoustic impedance and a second layer of a second material having a second acoustic impedance different from the first acoustic impedance. The first or the second layer comprises one or more structures of a third material, having a third acoustic impedance different from the first and second impedances, said structures forming an acoustic impedance modulation layer embedded in the first and/or the second layer.

The one or more structures comprise a semiconductor material with a dopant concentration sufficiently large to enable a change in mass density and/or acoustic phase velocity.

The BAW resonator of the present disclosure provide frequency shift without need for precise thickness deposition of different layers therein. Herein, the acoustic impedance modulation layer (AIML) enables to modulate the effective impedance of specific layer and therefore tune the operating frequency of the BAW resonator. Further, the AIML improves the acoustic confinement efficiency in the piezoelectric element of the BAW resonator. The AIML is also used to electrically shield any radiation and induced currents into the substrate of the BAW resonator.

In an implementation form, the reflective element is a Bragg layer comprising a plurality of interleaved first and second layers.

Herein, the reflective element being composed of alternating low impedance and high impedance acoustic material produce an acoustic reflector in the operating frequency of the BAW resonator which makes it possible to reflect, through phenomena of constructive interference, almost the totality of the incident energy. Further, interleaving of the first and second layers, with one being of low mechanical impedance and other being of relatively higher mechanical impedance, limit the leakage of energy to the substrate.

In an implementation form, the reflective element is composed of alternating layers of the first and second material in such a way that the reflecting element is arranged to operate in the operating frequency of the BAW resonator.

By allowing variation of the first and second material for the respective, alternating, first and second layers in the reflective element, with one of the first and second material being of low mechanical impedance and other being of relatively higher mechanical impedance, it is possible to tune the operating frequency of the BAW resonator.

In an implementation form, the acoustic impedance modulation layer is embedded in a layer of the reflective element adjacent the bottom electrode.

The AIML being embedded adjacent to the bottom electrode (i.e., upper core section of the reflective element) allow to reduce noise in the signal (i.e., unwanted signals), and thus reduces interference and degradation of the signal, to be operated as a spurious mode reduction region.

In an implementation form, the one or more structures have a thickness in the order of the acoustic wavelength or a fraction of the acoustic wavelength, at the fundamental operating frequency of the BAW resonator.

Herein, the thickness of the one or more structures enables to modify the effective density of the reflective element, which impacts the acoustic propagation constants, and in turn modifies the phase velocities of the bulk waves propagating in that specific region to define the operating frequency of the BAW resonator. Therefore, the thickness of the one or more structures are determined based on order of the acoustic wavelength or a fraction of the acoustic wavelength, at the fundamental operating frequency of the BAW resonator.

With the acoustic impedance modulation layer being made of semiconductor material, varying dopant concentration therein, varies mass density of the acoustic impedance modulation layer and thereby acoustic phase velocity of the signal. The change in mass density and /or acoustic phase velocity modifies the acoustic impedance associated therewith, and thus allows for tuning of the operating frequency of the BAW resonator.

In an implementation form, the acoustic impedance modulation layer is arranged so that it extends into two layers of the reflective element.

The AIML extends into both the first and second layers of the reflective element so as to provide a structural geometry of the reflective element to provide the required frequency shift.

In an implementation form, the structures are distributed asymmetrically to form the acoustic impedance modulation layer.

Herein, the structures are distributed asymmetrically to help in the case of lateral spurious mode build-up, by creating asymmetric boundary conditions. Further, asymmetry in the AIML allows for varying acoustic impedance and mass density which can be used to tune the BAW resonator to the desired operating frequency.

In an implementation form, a BAW resonator further comprises at least one mass load layer on the top electrode.

The mass load layer enables generating multiple frequencies on the same BAW resonator. The multiple frequencies are generated by varying thickness of the mass load layer.

In an implementation form, the mass load layer is embedded, or partially embedded in the top electrode. The mass load layer is embedded, or at least partially embedded in the top electrode to provide for easy manufacturability.

In an aspect, an integrated circuit package is provided. The integrated circuit package comprises at least a first and a second BAW resonator. The first and second BAW resonators having different acoustic impedance modulation layers.

The integrated circuit package with the BAW resonators of the present disclosure provide distinct frequencies on a same die without, generally or substantially, increasing its overall size. The present integrated circuit package does not require precise thickness of the different layers of the first and second BAW resonators to achieve the purpose, thus reducing manufacturing complexity and overall cost. Further, the integrated circuit package provides minimum frequency spacing resolution achievable by adjacent first and second BAW resonators.

In an implementation form, the integrated circuit package comprises a plurality of BAW resonators configured in a ladder structure or a lattice structure.

The ladder structure and the lattice structure enables to fully optimize the transmission characteristics of a filter made by the plurality of BAW resonators. Herein, the ladder structure presents a high rejection close to the filter passband but a poor out of band rejection. On the other hand, the lattice structure exhibits higher out of band rejection but a poor rejection close to the filter passband. The integrated circuit package may combine these two structure configurations to obtain a mixed ladder-lattice filter to achieve desired properties.

In an aspect, a method of manufacturing BAW resonator is provided. The method comprises the step of depositing a reflective element on a substrate, said reflective element comprising at least a first and a second layer from a first and a second material having a first and second acoustic impedance, respectively. The method further comprises placing one or more structures of a third material having a third acoustic impedance different from the first and the second acoustic impedance, in the first and/or the second layer, said structures forming an acoustic impedance modulation layer within the reflective element. The one or more structures comprise a semiconductor material with a dopant concentration sufficiently large to enable a change in mass density and/or acoustic phase velocity.

The present method enables to manufacture the BAW resonator that provides frequency shift without need for precise thickness deposition of different layers of the bulk acoustic wave resonator. The AIML enables modulation in effective acoustic impedance of the reflective element, and the modulation in the effective impedance tunes the operating frequency of the resonator. Further, the AIML improves the acoustic confinement efficiency in the piezoelectric element.

In an implementation form, the step of placing the one or more structures comprises depositing a third layer of the third material on a first or a second layer and etching the third layer to form the structures. The method further comprises covering the third layer with a covering layer of the first or the second material and planarizing the covering layer.

Deposition of the third material varies density of the third layer to enable for modulation of the effective impedance of the reflective element and therefore tuning of the operating frequency of the BAW resonator. Etching the third layer removes material therefrom, in a pattern to form the structures. Planarization of the covering layer provides smooth surface of the covering layer ensure proper deposition of the subsequent thin-films in the BAW resonator.

In an implementation form, the step of placing the one or more structures comprises etching a first or second layer to create spaces for the structures, depositing a third layer of the third material and planarizing the third layer.

Etching process removes material from the first or second layer in a pattern so that the third material is filled in the spaces created in the first or second layer to form the structures. The structures collectively form the third layer (i.e. the acoustic impedance modulation layer). The third layer is planarized to ensure proper deposition of the subsequent thin-films in the BAW resonator.

In an implementation form, the acoustic modulation layer is lithographically defined and formed using one lithographic mask for the whole substrate.

In the present method, the acoustic modulation layer is formed in one go throughout the wafer for different BAW resonator units in the integrated circuit package, and does not require individual process steps for forming different resonator units, thereby reducing manufacturing complexity, time and cost.

Additional aspects, advantages, features and objects of the present disclosure would be made apparent from the drawings and the detailed description of the illustrative implementations construed in conjunction with the appended claims that follow.

### BRIEF DESCRIPTION OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific methods and instrumentalities disclosed herein. Moreover, those in the art will understand that the drawings are not to scale. Wherever possible, like elements have been indicated by identical numbers.

Embodiments of the present disclosure will now be described, by way of example only, with reference to the following diagrams wherein:
- FIG. 1: is an exemplary cross-sectional illustration of a bulk acoustic wave (BAW) resonator, in accordance with an embodiment of the present disclosure;
- FIG. 2: is an exemplary cross-sectional illustration of a unit cell of the BAW resonator, in accordance with an embodiment of the present disclosure;
- FIGs. 3A-3C: are exemplary cross-sectional illustrations of the BAW resonator, in accordance with other embodiments of the present disclosure;
- FIG. 4A: is an exemplary top view of an integrated circuit package with two different acoustic impedance modulation layers therein, in accordance with an embodiment of the present disclosure;
- FIG. 4B: is an exemplary cross-sectional illustration of the integrated circuit package of FIG. 4A along an axis AA' thereof, in accordance with an embodiment of the present disclosure;
- FIG. 5: is a flowchart listing steps involved in a method of manufacturing a BAW resonator, in accordance with an embodiment of the present disclosure; and
- FIGs. 6A-6B: are exemplary graphical representations of frequency shift in a BAW resonator, in accordance with an embodiment of the present disclosure.

In the accompanying drawings, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

### DETAILED DESCRIPTION OF EMBODIMENTS

The following detailed description illustrates embodiments of the present disclosure and ways in which they can be implemented.

It will be understood that when an element such as a layer, region, or substrate is referred to as being "on" or "extending onto" another element, it can be directly on or extend directly onto the other element or intervening elements may also be present. In contrast, when an element is referred to as being "directly on" or "extending directly onto" another element, there are no intervening elements present. Likewise, it will be understood that when an element such as a layer, region, or substrate is referred to as being "over" or "extending over" another element, it can be directly over or extend directly over the other element or intervening elements may also be present. In contrast, when an element is referred to as being "directly over" or "extending directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the drawings.

The present disclosure generally relates to acoustic wave devices which are key components used in modern electronic circuits. Acoustic wave devices are often employed in filter networks that require a flat passband. In acoustic wave devices, high frequency selectivity while maintaining low electric insertion loss requires high quality factor mechanical resonators coupled in a filter topology. Bulk Acoustic Wave (BAW) devices are mechanical resonators which couple an electrical, time varying signal, to a mechanical wave traveling in the bulk of a piezoelectric material. The fundamental mode of vibration at which the BAW devices are electromechanically coupled to is the thickness-extensional mode (TE) which are longitudinal waves propagating in the thickness of the thin piezoelectric membrane material. In some cases, other classes of piezoelectric material can be used, in which case the fundamental mode of vibration can also be the thickness-shear mode (TS). That is, the role of the TE and TS are interchanged depending on the core mode of vibration of the chosen piezoelectric material.

In order to achieve high quality electric signal, the mechanical resonance, generated within the resonators, needs to be as efficient as possible and generate the least mechanical loss. Mechanical loss in a BAW device is primarily arising from the acoustic radiation of mechanical energy into the substrate through the reflective element. Other routes of mechanical loss are radiation and scattering of the energy at the resonator edges, location where Bragg layers/ reflective elements are not located. Further, as the number of filter and device count increase in electronic devices, stringent requirements on the overall implementation size of filters are required, therefore requiring a reduced floor-plan area of the resonators and a decrease in distance between the resonators. Furthermore, the performance of these highly integrated filter solutions needs to be maintained, while at the same time improving yield and process cost.

Multiple frequency elements in one integrated circuit package are therefore required in order to improve the end performance of the filter. Conventional BAW devices are produced using a thin piezoelectric layer, disposed over a reflective element. In the case of thin-film bulk acoustic resonators (FBAR), the reflective element is a cavity; while in the case of solidly mounted acoustic resonators (SMR), the reflective element is an acoustic mirror or Bragg reflector comprising alternating layers of high and low acoustic impedance materials. In the case of SMR-BAW, the frequency tuning is achieved through the use of mass loading elements with varying deposited thickness. However, varying the deposited thickness (which needs to be with very fine control) will increase the manufacturing complexity when this number of frequency counts increase.

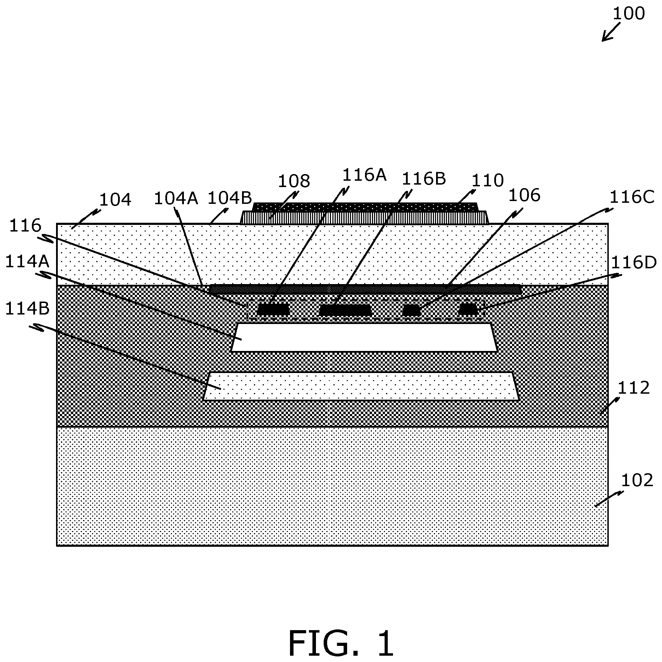

FIG. 1 is an exemplary illustration of a bulk acoustic wave (BAW) resonator **100,** in accordance with an embodiment of the present disclosure. The bulk acoustic wave resonator **100** is a micro-resonator that generates high-precision and ultra-low jitter signal of specific frequencies. The BAW resonator **100** is also capable of generating signals with variable frequencies in both wired and wireless circuits. For example, the BAW resonator **100** may generate variable frequencies in range of 100 megahertz to 20 gigahertz. The BAW resonator **100** may be used in global positioning systems, data transfer (such as WLAN and Bluetooth), cellular mobile systems (such as CDMA, UMTS, GSM), satellite communications and military applications.

The BAW resonator **100** is built on a substrate **102** (sometimes, also referred to as a bulk). In particular, the BAW resonator **100** is deposited on the substrate **102.** The substrate **102** acts as a base on which various elements or layers of the BAW resonator **100** are supported. The substrate **102** may be formed of various types of materials, including semiconductor materials compatible with semiconductor processes, which is useful for integrating connections and electronics, thus reducing size and cost. The substrate **102** may be fabricated using silicon, glass, ceramic, and a combination therefor. In an example, the substrate **102** may include, but is not limited to, silicon, silicon on insulator (SOI) technology substrate, gallium arsenide, gallium phosphide, gallium nitride, and indium phosphide. In another example, the substrate **102** may include an alloy semiconductor such as GaAsP, AllnAs, GaInAs, GalnP, GalnAsP or combinations thereof. In some examples, the BAW resonator **100** may include an electromagnetic shield provided on the substrate **102** that blocks radio frequency (RF) and electromagnetic radiation from adjacent resonator to reduce coupling losses such as eddy current losses in the substrate **102.**

The BAW resonator **100** comprises a piezoelectric element **104.** The piezoelectric element **104** is a layer of piezoelectric material that generates signals of desired resonance frequencies when an electric field (such as voltage) is applied to the piezoelectric element **104.** In the BAW resonator **100,** an electrical, time varying signal is coupled to a mechanical wave traveling in the bulk of the piezoelectric element **104.** Generally, the thickness of the piezoelectric element **104** determines frequency of generated signal by the BAW resonator **100,** and thus the frequency of the generated signal may be varied by varying the thickness of the piezoelectric element **104.** Generally, the piezoelectric element **104** is a planar structure; however, the piezoelectric element **104** may be formed to have other shapes that may include, but is not limited to a cylindrical, conical and alike without any limitations.

The piezoelectric element **104** is, typically, a combination of undoped piezoelectric material and doped piezoelectric material, where the doped piezoelectric material may be doped with at least one rare earth element. Combining the undoped and doped piezoelectric material improves piezoelectric properties of the piezoelectric element **104,** such as increasing the coupling coefficient over that of an entirely undoped piezoelectric material (e.g., Sc, Er). At the same time, the undoped and doped piezoelectric material reduces and more evenly distributes stress in the piezoelectric element **104,** thereby reducing total compressive stress and more evenly distributing compressive stress over the substrate **102.** In the present examples, the material used for fabricating the piezoelectric element **104** may include, but is not limited to, lithium niobate, lithium tantalate, aluminium nitride, zinc oxide and the like.

The BAW resonator **100** further comprises a bottom electrode **106** on a first face **104A** of the piezoelectric element **104** and a top electrode **108** on a second face **104B** of the piezoelectric element **104** facing away from the first face **104A.** The top electrode **108** is placed on the second face **104B** with direct contact with the piezoelectric element **104.** In other words, the piezoelectric element **104** is sandwiched between the bottom electrode **106** at the first face **104A** and the top electrode **108** at the second face **104B.** Generally, the bottom electrode **106** is a planar structure; however, the bottom electrode **106** may be formed to have other shapes that may include, but is not limited to, a cylindrical, conical and the like without any limitations. The thickness for the bottom electrode **106** is chosen to give optimum acoustic properties to the BAW resonator **100.** For instance, the thickness for the bottom electrode **106** is chosen to obtain maximum effective coupling and minimum Temperature Coefficient of Frequency (TCF).

The BAW resonator **100** is divided into an active region and an outside region. The active region generally corresponds to the section of the BAW resonator **100** where the bottom electrodes **106** and the top electrode **108** overlap and also includes the layers below the overlapping top and bottom electrodes **106** and **108.** The outside region corresponds to the section of the BAW resonator **100** that surrounds the active region and it is not electrically driven. Although shown in FIG. 1 as each including a single layer, the bottom electrode **106** and/or the top electrode **108** may include multiple layers of the same material, multiple layers in which at least two layers are different materials, or multiple layers in which each layer is a different material. In the present examples, the material used for fabricating the bottom electrode **106** may include, but is not limited to, tungsten, titanium, tantalum, molybdenum, platinum, iridium, ruthenium or a combination thereof, and the material used for fabricating the top electrode **108** may include, but is not limited to, molybdenum, platinum, tungsten and iridium.

In accordance with an embodiment, the BAW resonator **100** further comprises at least one mass load layer **110** on the top electrode **108.** The mass load layer **110** allows variations in thickness of the top electrode **108** of the BAW resonator **100.** The mass load layer **110** enables generation of multiple resonant frequencies in the BAW resonator **100** by allowing varying its thickness in the BAW resonator **100.** In an example, increase in thickness of the mass load layer **110** increases acoustic path length of the BAW resonator **100** which leads to a decrease of the resonant frequency thereof. In another example, decrease in thickness of the mass load layer **110** decreases acoustic path length of the BAW resonator **100** which leads to an increase of the resonant frequency thereof. In an alternate example, the BAW resonator **100** may include the mass load layer **110** on the bottom electrode **106** without departing from the scope of the present disclosure. In some examples, the BAW resonator **100** may include multiple mass load layers **110** on the top electrode **108** to further shift the resonant frequency thereof.

The mass load layer **110** may correspond to a thickened portion of the top electrode **108** or the application of additional layers of an appropriate material over the top electrode **108.** The mass load layer **110** extends about the periphery of the active region in the top electrode **108.** Thus, the portion of the BAW resonator **100** that includes and resides below the mass load layer **110** is referred to as an active region. In an example, the mass load layer **110** may be fabricated from a conductive substrate such as, but not limited to, tungsten, tungsten alloys, molybdenum, aluminium, iridium, and platinum. In another example, the mass load layer **110** may be fabricated from a dielectric material such as, but not limited to, silicon dioxide, silicon nitride, diamond, and amorphous aluminium nitride. In general, the mass load layer **110** may be a single metal layer like tungsten, or may be an alloy like AlCu or may be multiple layers of metal like tungsten and AlCu.

In accordance with an embodiment, the mass load layer **110** is embedded, or partially embedded in the top electrode **108.** The mass load layer **110** is embedded in the top electrode **108** by deposition of the mass loading material substantially along the edges of the top electrode **108** to define a border region. The defined border region area may have certain areas particularly at the corners depleted of metal allowing for the bottom electrode **106** to extend to a lead connection without experiencing a direct electric field. The mass load layer **110** may be provided as, by various examples, a frame-like structure formed from a metal heavier than the metal of the top electrode **108** and from various formations of the frame-like structure proximate the top electrode **108** including outside, above, below, and between a layered electrode. It may be appreciated that this is in contrast to conventional BAW resonators where the mass load layer is placed on the top electrode to generally create a mechanical loading and a downward shift in the operating frequency.

The BAW resonator **100** further comprising a reflective element **112** between the bottom electrode **106** and the substrate **102.** The reflective element **112** is also referred as an acoustic mirror or a Bragg reflector. The reflective element **112** comprises alternating layers of high and low acoustic impedance materials to generate resonance signal of desired frequency. The reflective element **112** may be manufactured using dielectric materials that may include, but not limited to, SiCOH, a phosphosilicate glass, an oxide or a nitride of aluminium, silicon, germanium, gallium, indium, tin, antimony, tellurium, bismuth, titanium, vanadium, chromium, manganese, cobalt, nickel, copper, zinc, zirconium, niobium, molybdenum, palladium, cadmium, hafnium, tantalum, tungsten, or a combination thereof. Optionally, the reflective element **112** may be manufactured using fibre grating or semiconductor material, such as silicon oxide.

The said reflective element **110** comprises at least a first layer **114A** of a first material having a first acoustic impedance and a second layer **114B** of a second material having a second acoustic impedance different from the first acoustic impedance. That is, the first layer **114A** and the second layer **114B** have different acoustic impedances. Acoustic impedance is the product of media density through which the signal travels and the velocity of the signal wave. Herein, the first layer **114A** and the second layer **114B** are made of different material for having different acoustic impedances. The materials with low acoustic impedance are typically low-density materials. In the present examples, the material used for low acoustic impedance layer (for example, the first layer **114A)** may include, but not limited to, silicon dioxide, aluminium and SiOC. Further, the materials with high acoustic impedance are typically high-density materials. In the present examples, the material used for high acoustic impedance layer (for example, the second layer **114B)** may include, but not limited to, iridium, molybdenum and tungsten.

In accordance with an embodiment, the reflective element **112** is composed of alternating layers of the first and second material in such a way that the reflecting element **112** is arranged to operate in the operating frequency of the BAW resonator. That is, the reflective element **112** comprises layers of low acoustic impedance material and high acoustic impedance material that are arranged alternately. For example, the reflective element **112** comprises the first layer **114A** followed by the second layer **114B** which is again followed by another first layer **114A** and another second layer **114B** so on to form alternate layers of the first layer **114A** and the second layer **114B.** This is done so to produce a significant reflection coefficient at the junction of adjacent layers in the reflective element **112.** The thickness and distance between the first layer **114A** and the second layer **114B** are determined based on an intended resonant frequency of the BAW resonator **100,** to cause constructive interference at that frequency. In one example, the thickness of the first layer **114A** and the second layer **114B** corresponds to one quarter of the wavelength of the designed frequency, and the distance between the first layer **114A** and the second layer **114B** is half the wavelength of the designed frequency.

In accordance with an embodiment, the reflective element **112** is a Bragg layer comprising a plurality of interleaved first and second layers **114A** and **114B.** Herein, the Bragg layer is a succession of planar surfaces with different acoustic impedances. It makes it possible to reflect, through phenomena of constructive interference, almost the totality of the incident signals. This is possible provided that the incident signal wave is close to the normal incidence. As discussed, the reflective element **112** includes a plurality of layers, including the first layer **114A** and the second layer **114B** that are spaced apart. The plurality of layers, including the first layer **114A** and the second layer **114B** are arranged alternatively in the Bragg layer configuration of the reflective element **112.** Each layer boundary causes a partial reflection of the signal wave. For waves whose vacuum wavelength is close to four times the thickness of the layers, many reflections combine with constructive interference, and thus the Bragg layer, overall, acts as a high-quality filter.

The first or the second layer **114A** and **114B** comprises one or more structures of a third material, having a third acoustic impedance different from the first and second impedances, said structures forming an acoustic impedance modulation layer **116** embedded in the first and/or the second layer **114A** and **114B.** In an example, the acoustic impedance modulation layer **116** may be embedded either in the first layer **114A** or the second layer **114B.** In another example, the acoustic impedance modulation layer **116** may be embedded in both the first layer **114A** and the second layer **114B.** In the example illustration of FIG. 1, the first layer **114A** is shown to include four structures **116A, 116B, 116C** and **116D** collectively forming the acoustic impedance modulation layer **116.** The structures **116A, 116B, 116C** and **116D** are distinct patches on the first layer **114A** that are used to tune the operating frequency of the BAW resonator **100.** In an example not covered by the invention, the acoustic impedance modulation layer **116** is formed of a dielectric material that may include, but not limited to, SiN, SiO2, AIN or a combination thereof. In another example not covered by the invention, the acoustic impedance modulation layer **116** is formed of a conductor material that may include, but not limited to, aluminium, tungsten, platinum and combination thereof. Specifically, the structures **116A, 116B, 116C** and **116D** are made of the third material different from the first material of the first layer **114A** and the second material of the second layer **114B,** with the third material having the third acoustic impedance different from the first acoustic impedance of the first layer **114A** and the second acoustic impedances of the second layer **114B.**

The different acoustic impedances (as well as different densities due to different corresponding materials) of the first layer **114A,** the second layer **114B** and the acoustic impedance modulation layer **116** enables to modify the effective impedance (as well as effective density) of the reflective element **112.** The modulation in the effective impedance directly impacts acoustic propagation constants, which in turns modifies velocity of the signal in that specific region and thus, impacts the overall operating frequency of the BAW resonator **100.** This way the acoustic impedance modulation layer **116** tunes the operating frequency of the BAW resonator **100.** Further, the acoustic impedance modulation layer **116** improve the acoustic confinement efficiency in the piezoelectric element **104.** In some examples, the acoustic impedance modulation layer **116** may further be pattemed to vary density of the one or more structures **116A, 116B, 116C** and **116D** to enhance modulation of the effective impedance of the reflective element **112** and therefore tune the operating frequency of the BAW resonator **100.**

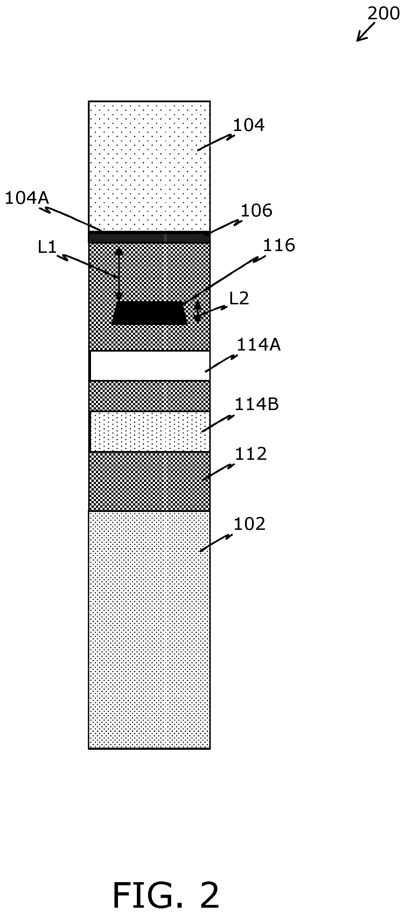

FIG. 2 is an exemplary illustration of a unit cell **200** of the BAW resonator (such as, the BAW resonator **100** of FIG. 1), in accordance with an embodiment of the present disclosure. FIG. 2 has been described in conjunction with elements from FIG. 1. With reference to FIG. 2, there is shown relative position and deposition thickness of different components or layers of the BAW resonator **100.** As illustrated, the BAW resonator **100** comprises the substrate **102** as a bottom layer and the piezoelectric element **104** as a top layer. The reflective element **112** is placed between the substrate **102** and the piezoelectric element **104.** The bottom electrode **106** is placed on the first face **104A** of the piezoelectric element **104** between the piezoelectric element **104** and the reflective element **112.** The reflective element **112** comprises the acoustic impedance modulation layer **116** arranged with the first layer **114A** or the second layer **114B.** As shown, the acoustic impedance modulation layer **116** is embedded near the bottom electrode **106** at a distance of **L1** from the bottom electrode **106.** Further, the acoustic impedance modulation layer **116** has a deposition thickness of L2.

In accordance with the invention, the one or more structures **116A, 116B, 116C** and **116D** comprise a semiconductor material with a dopant concentration sufficiently large to enable a change in mass density and /or acoustic phase velocity. Herein, the acoustic impedance modulation layer **116** comprises the semiconductor material with varying dopant concentration to vary mass density thereof and acoustic phase velocity of the resonance signal generated by the BAW resonator **100.** It may be contemplated that such change in mass density and /or acoustic phase velocity overall modifies the third acoustic impedance in the reflective element **112.** Thus, the semiconductor material in the acoustic impedance modulation layer **116** allows tuning of the operating frequency of the bulk acoustic wave resonator **100.** In the present examples, the semiconductor material may be n-type or p-type material. In an example, the semiconductor material used for the one or more structures may include, but is not limited to, silicon, germanium, silicon carbide, silicon germanium, boron, arsenic, phosphorus and a combination thereof.

In accordance with an embodiment, the one or more structures **116A, 116B, 116C** and **116D** have a thickness in the order of the acoustic wavelength or a fraction of the acoustic wavelength, at the fundamental operating frequency of the BAW resonator **100.** As discussed earlier, it may be appreciated that the thickness of the structures **116A, 116B, 116C** and **116D** is determined based on an intended resonant frequency of the BAW resonator 100. In the BAW resonator **100** of the present disclosure, the thickness of the one or more structures **116A, 116B, 116C** and **116D** corresponds to one quarter of the wavelength of the intended frequency. Further, the fundamental operating frequency of the BAW resonator **100,** generally, decreases with increase in the thickness of the one or more structures **116A, 116B, 116C** and **116D.**

In accordance with an embodiment, the structures **116A, 116B, 116C** and **116D** are distributed asymmetrically to form the acoustic impedance modulation layer **116.** Herein, the acoustic impedance and the density of the acoustic impedance modulation layer **116** is varied through variations in implementations of the structures **116A, 116B, 116C** and **116D** therein. This way the asymmetry in the acoustic impedance modulation layer **116** allows for varying acoustic impedance and mass density thereof, which can be used to tune the BAW resonator **100** to the desired operating frequency. In particular, the asymmetry in distribution of the structures **116A, 116B, 116C** and **116D** helps in the case of lateral spurious mode build-up, by creating asymmetric boundary conditions. Herein, the positions of the structures **116A, 116B, 116C** and **116D** in the reflective element **112,** in order to form the acoustic impedance modulation layer **116,** are determined according to the frequency shift required to tune the BAW resonator **100.** Further, the structural geometry of the structures **116A, 116B, 116C** and **116D,** in order to form the acoustic impedance modulation layer **116,** is also determined according to the frequency shift required to tune the BAW resonator **100.**

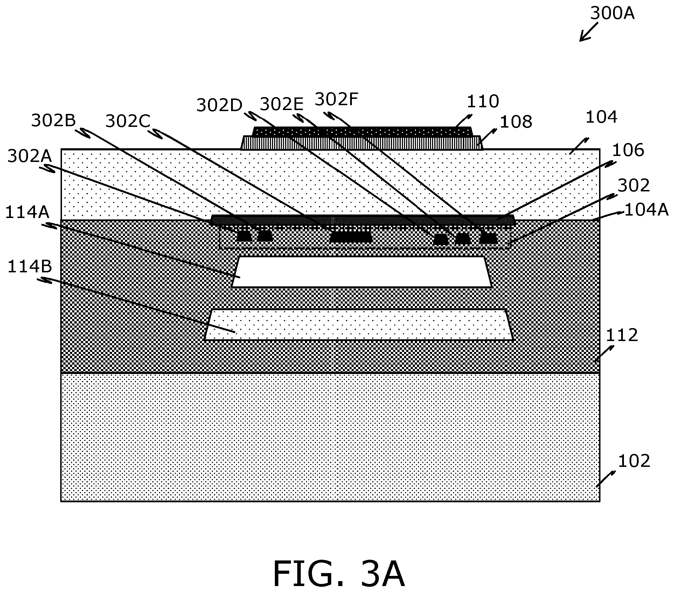

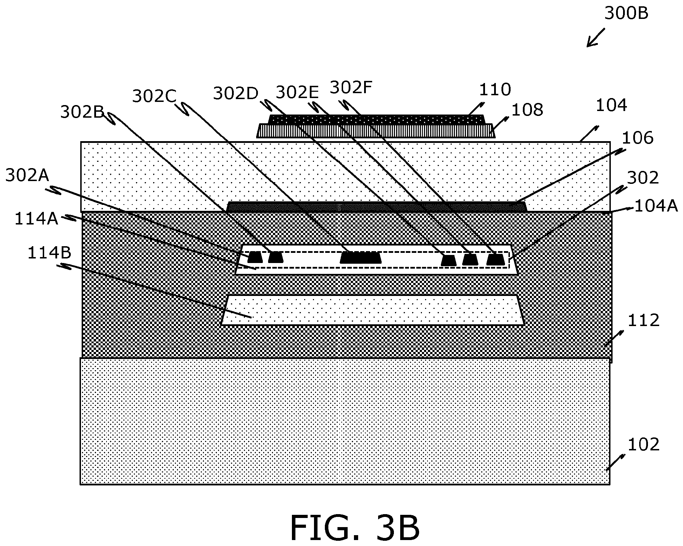

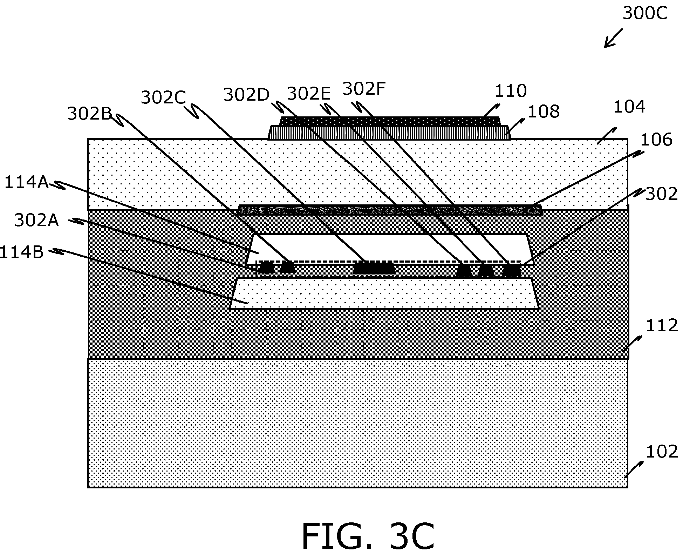

FIG. 3A is an illustration of a BAW resonator **300A,** in accordance with another embodiment of the present disclosure. FIG. 3 is described in conjunction with elements of the BAW resonator **100** from FIG. 1 which are generally similar in configuration. The BAW resonator **300A** comprises the substrate **102** and the piezoelectric element **104.** The BAW resonator **300A** also comprises the reflective element **112** between the substrate **102** and the piezoelectric element **104.** The BAW resonator **300A** further comprises the bottom electrode **106** between the first face **104A** of the piezoelectric element **104** and the reflective element **112.** The reflective element **112** comprises an acoustic impedance modulation layer **302** formed in the first layer **114A** and/or the second layer **114B.**

The acoustic impedance modulation layer **302** comprises a plurality of structures **302A, 302B, 302C 302D, 302E** and **302F.** The structures **302A, 302B, 302C 302D, 302E** and **302F** are distributed asymmetrically to form the acoustic impedance modulation layer **302.** The asymmetry in arrangement of the structures **302A, 302B, 302C 302D, 302E** and **302F** provides variation in mass density and acoustic phase velocity of the signal of the acoustic impedance modulation layer **302** that enables variable acoustic impedance in the acoustic impedance modulation layer **302.** Hence, asymmetry in arrangement of the structures **302A, 302B, 302C 302D, 302E** and **302F** enables tuning of the BAW resonator **300A** to define its operating frequency. Further, asymmetry in arrangement of the structures **302A, 302B, 302C 302D, 302E** and **302F** cancels unwanted signals and noises in the signal thus, reduces interference and degradation of the signal. Thereby, the asymmetry helps in the case of lateral spurious mode build-up by creating asymmetric boundary conditions. In the present embodiments, the position of the structures **302A, 302B, 302C 302D, 302E** and **302F,** in order to form the acoustic impedance modulation layer **302,** are determined according to the frequency shift required to tune the BAW resonator **300A.** Further, the structural geometry and the thickness of the structures **302A, 302B, 302C 302D, 302E** and **302F,** in order to form the acoustic impedance modulation layer **302,** are also determined according to the frequency shift required to tune the BAW resonator **300A.**

In accordance with an embodiment, the acoustic impedance modulation layer **116** is embedded in a layer of the reflective element **112** adjacent the bottom electrode **106.** The acoustic impedance modulation layer **116** being embedded adjacent to the bottom electrode **106** (i.e., upper core section of the reflective element **112)** allow to reduce noise in the signal (i.e., unwanted signals), and thus reduces interference and degradation of the signal. This way the acoustic impedance modulation layer **116** is operated as a spurious mode reduction region due to the build-up of lateral traveling waves. Depending on the dispersion characteristics of these laterally propagating mode, the acoustic impedance modulation layer can provide the necessary boundary condition at the edges of the core resonator region to reduce the build-up of spurious modes. This has a strong influence on performance of the BAW resonator **100.** Alternatively, the acoustic impedance modulation layer **116** may be embedded in the reflective element **112** adjacent to the substrate **102** without departing from the scope and the spirit of the present disclosure.

FIG. 3B is an illustration of a BAW resonator **300B,** in accordance with yet another embodiment of the present disclosure. FIG. 3B is described in conjunction with elements of the BAW resonator from FIGs. 1 and 3A which are generally similar in configuration. The BAW resonator **300B** comprises the substrate **102** and the piezoelectric element **104.** The BAW resonator **300B** also comprises the reflective element **112** between the substrate **102** and the piezoelectric element **104.** The BAW resonator **300B** further comprises the bottom electrode **106** between the first face **104A** of the piezoelectric element **104** and the reflective element **112.** The reflective element **112** comprises an acoustic impedance modulation layer **302** formed in the first layer **114A** and/or the second layer **114B.** The acoustic impedance modulation layer **302** comprises a plurality of structures **302A, 302B, 302C 302D, 302E** and **302F.** The structures **302A, 302B, 302C 302D, 302E** and **302F** are embedded in the first layer **114A** of the reflective element **112** adjacent the bottom electrode **106.**

Herein, the acoustic impedance modulation layer **302** is embedded in the first layer **114A.** In an implementation, first the third material is deposited on the first layer **114A,** then the acoustic impedance modulation layer **302** is etched by forming the structures **302A, 302B, 302C 302D, 302E** and **302F,** and thereafter the acoustic impedance modulation layer **302** is covered with the covering layer (not shown) of the first material of the first layer **114A.** In another implementation, first the first layer **114A** is etched to create spaces to form the structures **302A, 302B, 302C 302D, 302E** and **302F,** then the third material is deposited in the formed structures **302A, 302B, 302C 302D, 302E** and **302F** to form the acoustic impedance modulation layer **302,** and thereafter the acoustic impedance modulation layer **302** is covered with the covering layer (not shown) of the first material of the first layer **114A.** In some examples, the acoustic impedance modulation layer **302** is planarized before embedding (i.e. before applying the covering layer) in the first **114A** that significantly improves smoothness of the surface of the acoustic impedance modulation layer **302.** Planarization of the surface of the acoustic impedance modulation layer **302** may be performed using chemical mechanical polishing (CMP) technique, for instance.

In accordance with an embodiment, the acoustic impedance modulation layer **116** is arranged so that it extends into two layers of the reflective element **112.** Herein, the acoustic impedance modulation layer **116** extends into the first layer **114A** and the second layer **114B.** As discussed, in some examples, the acoustic impedance modulation layer **116** may be embedded in both the first layer **114A** and the second layer **114B.** According to an embodiment, the third layer of the third material is deposited on the first or the second layer **114A** and **114B,** and then the third layer is etched to form the structures **116A, 116B, 116C** and **116D,** and thereafter the third layer is covered with a covering layer (not shown) of the first or the second material. According to another embodiment, the first or the second layer **114A** and **114B** is etched to create spaces to form the structures **116A, 116B, 116C** and **116D,** and then the third layer of the third material is deposited thereon. In some examples, the acoustic impedance modulation layer **116** is planarized before embedding in the first **114A** and/or the second layer **114B** that significantly improves smoothness of the surface of the acoustic impedance modulation layer **116.** Planarization of the surface of the acoustic impedance modulation layer **116** may be performed using chemical mechanical polishing (CMP) technique, for instance.

FIG. 3C is an illustration of a BAW resonator **300C,** in accordance with still another embodiment of the present disclosure. FIG. 3C is described in conjunction with elements of the BAW resonator from FIGs. 1, 3A and 3B which are generally similar in configuration. The BAW resonator **300C** comprises the substrate **102** and the piezoelectric element **104.** The BAW resonator **300C** also comprises the reflective element **112** between the substrate **102** and the piezoelectric element **104.** The BAW resonator **300C** further comprises the bottom electrode **106** between the first face **104A** of the piezoelectric element **104** and the reflective element **112.** The reflective element **112** comprises an acoustic impedance modulation layer **302** formed in the first layer **114A** and/or the second layer **114B.** The acoustic impedance modulation layer **302** comprises a plurality of structures **302A, 302B, 302C 302D, 302E** and **302F.** The structures **302A, 302B, 302C 302D, 302E** and **302F** are embedded in both the first layer **114A** and second layer **114B** of the reflective element **112.**

Herein, the acoustic impedance modulation layer **302** is extending into and embedded in both the first layer **114A** and second layer **114B.** In an implementation, the third material is deposited between the first layer **114A** and second layer **114B,** and then the structures **302A, 302B, 302C 302D, 302E** and **302F** are etched therein to form the acoustic impedance modulation layer **302.** In another implementation, the gap between the first layer **114A** and second layer **114B** is etched to create spaces, and then the formed spaces are deposited (i.e. filed) with the third material to form the structures **302A, 302B, 302C 302D, 302E** and **302F** with the acoustic impedance modulation layer **302** therein.

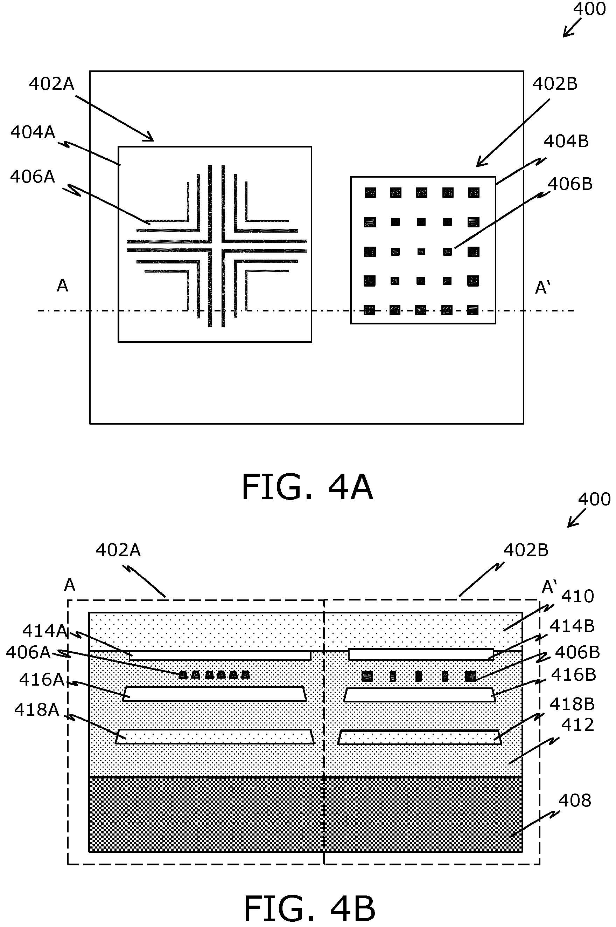

FIGS. 4A-4B are illustrations of an integrated circuit package **400,** in accordance with an embodiment of the present disclosure. Examples of the integrated circuit package **400** includes, but are not limited to, a digital logic circuit, an analog circuit, a processor core, a digital signal processor (DSP) core etc. The integrated circuit package **400** may be made of any suitable material, and may have any suitable shape, dimensions, etc. without any limitations. The integrated circuit package **400** may be a wafer-level package, or a die-level package. For example, the integrated circuit package **400** may include a plurality of identical, integrally connected wafer portions that each contain identical structure and circuitry. These identical portions may later be separated in a die forming process, if required. The integrated circuit package **400** of the present disclosure may include a Microelectromechanical (MEMS) structure, such as bulk acoustic wave (BAW) structure, formed at the top of the wafer. Multiple MEMS structures, such as BAW structures or others, could be provided on each wafer portion, or such multiple MEMS structures could be contained in one or multiple cavities in wafer portions.

The integrated circuit package **400** comprises at least a first and a second BAW resonator **402A** and **402B.** In the present embodiments, the integrated circuit package **400** is a semiconductor-based device (or a chip) having the first and the second BAW resonators **402A** and **402B** connected to each other. Although, in the illustration of FIGs. 4A-4B, the integrated circuit package **400** is shown to include two BAW resonators, namely the first BAW resonator **402A** and the second BAW resonator **402B;** however, it may be appreciated that the integrated circuit package **400** may include more than two BAW resonators without any limitations.

Hereinafter, FIGs. 4A-4B have been described in conjunction with elements described in FIGs. 1 and 3. In some examples, the first BAW resonator **402A** and the second BAW resonator **402B** may be similar to each other. However, in preferred examples, the first BAW resonator **402A** and the second BAW resonator **402B** are different in configuration from each other to generate different resonance frequencies in the integrated circuit package **400.** In an embodiment, the first BAW resonator **402A** and the second BAW resonator **402B** may be similar to the BAW resonator **300A,** as discussed in the preceding paragraphs. Herein, the first BAW resonator **402A** and the second BAW resonator **402B** have different acoustic impedance modulation layers. That is, the first BAW resonator **402A** has an acoustic impedance modulation layer **404A** similar to the acoustic impedance modulation layer **116** and the second BAW resonator **402B** has an acoustic impedance modulation layer **404B** similar to the acoustic impedance modulation layer **302.** Different acoustic impedance modulation layers **404A** and **404B** allow multiple frequencies on the same integrated circuit package **400** without any need for precise thickness deposition of different layers of the first BAW resonator **402A** and the second BAW resonator **402A** (as conventionally required).

As discussed, the first BAW resonator **402A** and the second BAW resonator **402B** may each include corresponding acoustic impedance modulation layer **404A** and **404B.** As depicted in FIGs. 4A-4B, the acoustic impedance modulation layer **404A** of the first BAW resonator **402A** includes one or more structures **406A,** and the acoustic impedance modulation layer **404B** of the second BAW resonator **402B** includes one or more structures **406B.** It may be appreciated that different acoustic impedance modulation layers **404A** and **404B** may be formed by using different patterns, geometries, relative positions, doping concentrations, and the like of the one or more structures **406A** and **406B** therein.

As shown, the integrated circuit package **400** has a generally flat top surface and a generally flat bottom surface. The integrated circuit package **400** includes a substrate **408** (similar to the substrate **102)** common to the first BAW resonator **402A** and the second BAW resonator **402B,** onto which the first BAW resonator **402A** and the second BAW resonator **402B** are deposited. The integrated circuit package **400** also includes a piezoelectric layer **410** (similar to the piezoelectric layer **104)** and a reflective element **412** (similar to the reflective element **112).** The first BAW resonator **402A** includes a bottom electrode **414A** and the second BAW resonator **402B** comprises a bottom electrode **414B** (both similar to the bottom electrode **106).**

Further, the reflective element **412** comprises alternating layers of high and low acoustic impedance materials to generate signal of desired frequency. In particular, the reflective element **412** includes a first layer **416A** and a second layer **418A** for the first BAW resonator **402A,** and a first layer **416B** and a second layer **418B** for the second BAW resonator **402B.** The first layers **416A, 416B** and the corresponding second layers **418A, 418B** are the layers of different acoustic impedances. The first layers **416A, 416B** have the first acoustic impedance and the second layers **418A, 418B** have the second acoustic impedance, with, for example, the first acoustic impedance being lower than the second acoustic impedance.

In the present embodiments, the structures **406A** and **406B** reduce radio frequency and eddy current loss to the substrate **408** by opening out a current loop formation. The structures **406A** and **406B** comprise varying pitch and patch size throughout to form the corresponding acoustic impedance modulation layers **404A** and **404B.** The varying pitch and patch size enable asymmetry in the acoustic impedance modulation layers **404A** and **404B** that helps in the case of lateral spurious mode build-up by creating asymmetric boundary conditions.

In accordance with an embodiment, the integrated circuit package **400** comprises a plurality of BAW resonators **402A** and **402B** configured in a ladder structure or a lattice structure. As the integrated circuit package **400** is used to construct a micro-mechanical filter with fine optimization possible of the in-band ripple, herein the micro-mechanical filter is obtained by electrical interconnection of multiple individual BAW resonators similar to that of the BAW resonators **402A** and **402B** in either the ladder type structure or the lattice type structure. In a ladder structure, multiple BAW resonators **402A** and **402B** are arranged in a series-shunt configuration. For example, the first BAW resonator **402A** is arranged in series followed by the second BAW resonator **402B** which is arranged in shunt, and which is again followed by the first BAW resonator **402A** arranged in series and so on. In the lattice structure, multiple BAW resonators **402A** and **402B** are arranged as crystal lattice. The ladder structure and the lattice structure enables to fully optimize the transmission characteristics of a filter provided by the integrated circuit package **400** made by the plurality of BAW resonators **402A** and **402B.** Herein, the ladder structure presents a high rejection close to the filter passband but a poor out of band rejection. On the other hand, the lattice structure exhibits higher out of band rejection but a poor rejection close to the filter passband. The integrated circuit package **400** may combine these two structure configurations to obtain a mixed ladder-lattice filter to achieve desired properties.

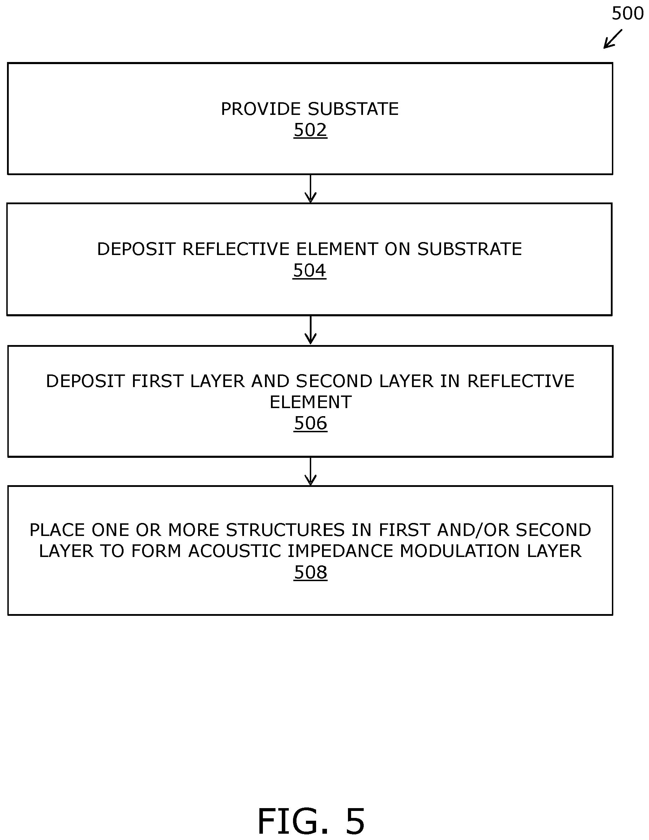

FIG. 5 is a flowchart of a method **500** of manufacturing a BAW resonator, in accordance with an embodiment of the present disclosure. The various embodiments and variants disclosed above apply mutatis mutandis to the method of manufacturing the BAW resonator.

At step **502,** a substrate (such as, the substrate **102** of FIG. 1) is provided. The substrate acts as a base on which various elements or layers of the BAW resonator are supported. At step **504,** a reflective element (such as, the reflective element **112** of FIG. 1) is deposited on a substrate (such as, the reflective element **102** of FIG. 1). The reflective element is also referred as an acoustic mirror or a Bragg reflector. The reflective element comprises alternating layers of high and low acoustic impedance materials to generate resonance signal of desired frequency. Further, a piezoelectric element (such as, the piezoelectric element **104** of FIG. 1) is deposited on the reflective element.

At step **506,** a first layer and a second layer (such as, the first layer **114A** and the second layer **114B** of FIG. 1) are deposited on the reflective element. The first and the second layer are fabricated from a first and a second material having a first and second acoustic impedance, respectively. That is, the first layer and the second layer are the layers of different acoustic impedances. The first layer has the first acoustic impedance and the second layer has the second acoustic impedance. The material used for low acoustic impedance layer (for example, the first layer) may include, but is not limited to silicon dioxide, aluminium and SiOC. The material used for high acoustic impedance layer (for example, the second layer) may include, but is not limited to iridium, molybdenum and tungsten. The reflective element is composed of alternating layers of the first and second layer in such a way that the reflecting element is arranged to operate in the operating frequency of the BAW resonator. For example, the reflective element comprises the first layer followed by the second layer which is again followed by another the first layer and so on to form alternate layers of the first layer and the second layer.

At step **508,** one or more structures of a third material having a third acoustic impedance different from the first and the second acoustic impedance is placed in the first and/or the second layer. The said structures forms an acoustic impedance modulation layer (similar to the acoustic impedance modulation layer **116** of FIG. 1) within the reflective element. The acoustic impedance modulation layer is embedded either in the first layer or/and the second layer. The different acoustic impedances of the first layer, the second layer and the acoustic impedance modulation layer enables to modify the effective impedance (as well as effective density) of the reflective element. The modulation in the effective impedance directly impacts acoustic propagation constants, which in turns modifies velocity of the signal in that specific region and thus, impacts the overall operating frequency of the resonator. Thus, the acoustic impedance modulation layer tunes the operating frequency of the BAW resonator. Further, the acoustic impedance modulation layer generates multiple resonant frequencies from the same BAW resonator without need of controlling precise thickness of different layers of the resonator. Further, the acoustic impedance modulation layer improves the acoustic confinement efficiency in piezoelectric element of the BAW resonator.

In accordance with an embodiment, the step of placing the one or more structures comprises depositing a third layer of the third material on a first or a second layer and etching the third layer to form the structures, the method further comprising covering the third layer with a covering layer of the first or the second material and planarizing the covering layer. Etching process is used to remove material from the acoustic impedance modulation layer (i.e. the third layer) in a pattern to form the structures. The material may be removed by coating the acoustic impedance modulation layer with photoresist or a hard mask (usually oxide or nitride) and exposing the acoustic impedance modulation layer to a pattern during photolithography. The structures vary density of the third layer to enables to modulate the effective impedance of the reflective element and therefore tune the operating frequency of the BAW resonator. Further, the structures enable to generate multiple resonant frequencies from the same BAW resonator. Thus, the structures of the acoustic impedance modulation layer dictate the frequency shifts and enables a fine control of the frequency spacing in the BAW resonator. Further, the covering layer comprises of either the first or the second material (depending on the which of the first layer or the second layer is etched) is deposited. The covering layer is planarized to ensure proper deposition of the subsequent thin-films in the BAW resonator. The covering layer may be planarized using chemical mechanical polishing (CMP) technique that uses combined chemical and mechanical methods involving an abrasive and corrosive chemical slurry (commonly a colloid) to achieve ultra-precision polishing of the surface of the covering layer, and thereby the third layer in the reflective element.

In accordance with an embodiment, the step of placing the one or more structures comprises etching a first or second layer to create spaces for the structures, depositing a third layer of the third material and planarizing the third layer. Etching process may be used to remove material from the first or second layer in a pattern so that the third material is filled in the spaces created in the first or second layer to form the structures. The structures collectively form the acoustic impedance modulation layer for the BAW resonator. Herein, the third layer is planarized to ensure proper deposition of the subsequent thin-films in the BAW resonator. The third layer may be planarized using chemical mechanical polishing (CMP) technique that uses combined chemical and mechanical methods involving an abrasive and corrosive chemical slurry (commonly a colloid) to achieve ultra-precision polishing of the surface of the third layer.

In accordance with an embodiment, the acoustic modulation layer is lithographically defined and formed using one lithographic mask for the whole substrate. Lithographically defined acoustic impedance modulation layer allows multiple frequencies to be designed on one substrate. Hence, if we need N separate frequencies, we don't need N different process steps to form each of the different N resonators. It will be appreciated that the lithographically defined acoustic impedance modulation layer provides minimum frequency spacing resolution between adjacent resonators. Using one lithographic mask for the whole substrate, the acoustic modulation layer is formed in one go throughout the wafer for different BAW resonator units in the integrated circuit package, and does not require individual process steps for forming different resonator units, thereby reducing manufacturing complexity, time and cost.

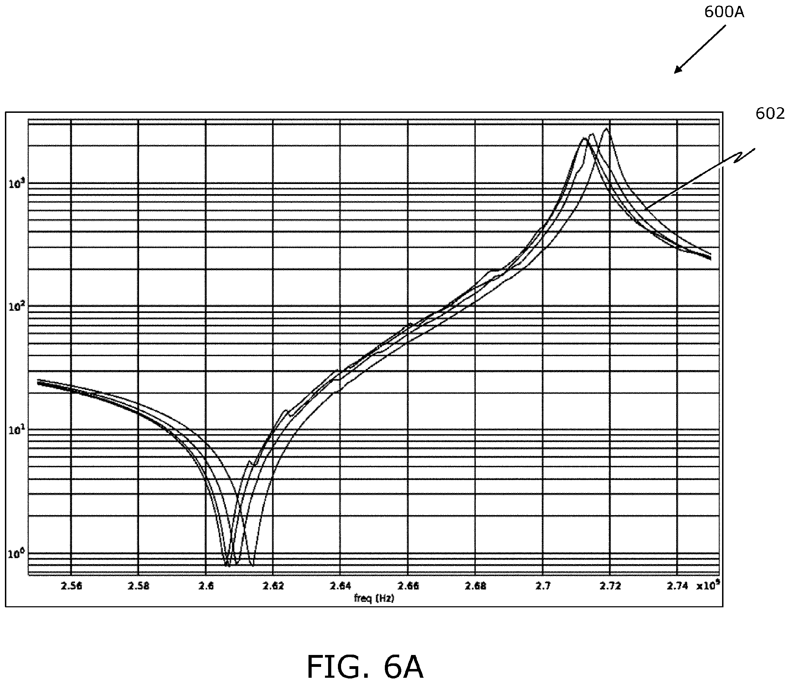

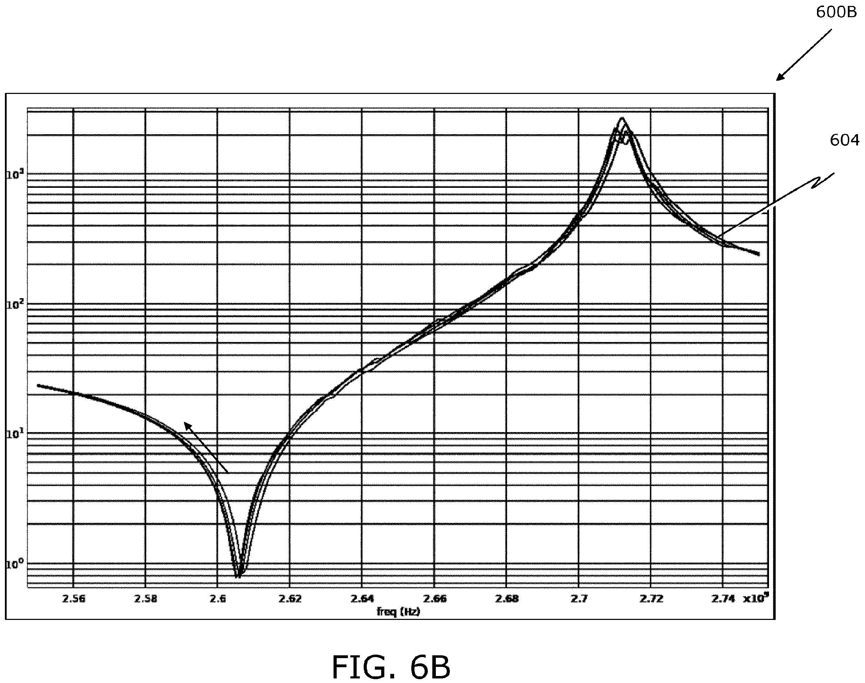

FIGs. 6A-6B are exemplary graphical representations of frequency shift in the BAW resonator **100,** in accordance with an embodiment of the present disclosure. With reference to FIG. 6A, the graphical representation **600A** represents frequency shifting of the BAW resonator **100** with a/p ratio of 2. Herein, the a/p ratio is the ratio between surface and perimeter of the BAW resonator **100.** The a/p ratio depends on the shape of the resonator. For a given value of 'a', a/p is larger for a square than for a triangle and is the largest for a circle. Independent of the shape, a/p ratio always increases with increasing value of 'a'. Therefore, large resonators have large value of a/p ratio, and small resonators have comparatively small value of a/p ratio. In the graphical representation **600A,** line **602** represents frequency shift of the BAW resonator **100.** The frequency shift is achieved by the acoustic impedance modulation layer of the BAW resonator **100.** With reference to FIG. 6B, there is also shown a graphical representation **600B** that represents frequency shifting of the BAW resonator **100** when a/p ratio of the BAW resonator **100** is 4. In the graphical representation **600B,** line **604** represents frequency shift of the BAW resonator **100.** The frequency shift is achieved by the same acoustic impedance modulation layer of the BAW resonator **100.** Hence, it may be understood that modulation in a range of frequency shift is obtained depending on the design from single BAW resonator **100** by using the acoustic impedance modulation layer configuration. It is to be noted that, herein, the quality factor (Q) and electromechanical coupling coefficient (kt2) factors are maintained. The configuration provides fine frequency tuning wit =h ripple enhancement (similar to SAW resonators). Further, it may be understood that the dispersion type of BAW resonator can be shifted (via lithography) to provide spurious mode suppression options.

The BAW resonator **100** of the present disclosure relies on the deposition and patterning of the acoustic impedance modulation layer **116** in the upper core section of the reflective element **112.** The inclusion of distinct material patches in this upper core section of the reflective element **112** enables to modify the effective density of the first layer **114A** (or, the second layer **114B),** which directly impacts the acoustic propagation constants, which in turns modifies the phase velocities of the bulk waves propagating in that specific region. This modification of acoustic parameters impacts the overall operating frequency of the BAW resonator **100.** It is to be noted that this tuning of the effective impedance and effective density is solely done through variations in implementations of the patterned shape of the acoustic impedance modulation layer **116.** The acoustic impedance modulation layer **116** is patterned in one go on the full wafer surface and enables a lithographically defined modulation of effective density of the first layer **114A** (or, the second layer **114B).** Adjacent BAW resonators can therefore have distinct frequencies even though they are located on the same die.

The present BAW resonator **100** achieves frequency shift setup by lithography of the acoustic impedance modulation layer **116** without need for precise thickness deposition (as conventionally required). With such design, many frequencies can be achieved on same wafer and fine optimizations are possible of the in-band ripple. Herein, the acoustic impedance modulation layer **116** can be setup close to the bottom electrode **106** (i.e. close to edge of the BAW resonator **100)** and thus can operate as a spurious mode reduction/ frame region. The acoustic impedance modulation layer **116** is also used to electrically shield any radiation and induced currents into the substrate **102.** Further, the acoustic impedance modulation layer **116** adds an additional optimization parameter to improve the acoustic confinement efficiency in the piezoelectric element **104.** Furthermore, the acoustic impedance modulation layer **116** with the added dummy elements can significantly improve the planarization of the surface prior to the deposition of the core piezoelectric element **104.**

Bulk Acoustic Wave (BAW) resonator of the present disclosure can be used in many high-frequency, communication applications. In particular, the present BAW resonator can be employed in filter networks that operate at frequencies above 1.5 GHz and require a flat passband; have exceptionally steep filter skirts and squared shoulders at the upper and lower ends of the passband; and provide excellent rejection outside of the passband. The present BAW resonator has relatively low insertion loss, tend to decrease in size as the frequency of operation increases, and are relatively stable over wide temperature ranges. As such, the present BAW resonator can be used in many 3rd Generation (3G) and 4th Generation (4G) wireless devices, and further in filter applications for 5th Generation (5G) wireless devices. It may be understood that these wireless devices support cellular, wireless fidelity (Wi-Fi), Bluetooth, and/or near field communications on the same wireless device, and as such, pose extremely challenging filtering demands which can be handled by the BAW resonator of the present disclosure.

## Claims

1. A bulk acoustic wave, BAW, resonator (100, 300A-C, 402A, 402B) on a substrate (102, 408), comprising a piezoelectric element (104), a bottom electrode (106, 414A, 414B) on a first face (104A) of the piezoelectric element (104) and a top electrode (108) on a second face (104B) of the piezoelectric element (104) facing away from the first face (104A), the BAW resonator (100, 300A-C, 402A, 402B) further comprising a reflective element (112, 412) between the bottom electrode (106, 414A, 414B) and the substrate (102, 408), said reflective element (112, 412) comprising at least a first layer (114A, 416A, 416B) of a first material having a first acoustic impedance and a second layer (114B, 418A, 418B) of a second material having a second acoustic impedance different from the first acoustic impedance, wherein the first or the second layer (114A, 416A, 416B ,114B, 418A, 418B) comprises one or more structures (116A-D, 302A-F, 406A-B) of a third material, having a third acoustic impedance different from the first and second impedances, said structures (116A-D, 302A-F, 406A-B) forming an acoustic impedance modulation layer (116, 302, 404A, 404B) embedded in the first and/or the second layer (114B, 418A, 418B), **characterized in that** the one or more structures (116A-D, 302A-F, 406A-B) comprise a semiconductor material with a dopant concentration sufficiently large to enable a change in mass density and /or acoustic phase velocity.

2. The BAW resonator (100, 300A-C, 402A, 402B) according to claim 1, wherein the reflective element (112, 412) is a Bragg layer comprising a plurality of interleaved first and second layers (114B, 418A, 418B).

3. The BAW resonator (100, 300A-C, 402A, 402B) according to claim 1 or 2 wherein the reflective element (112, 412) is composed of alternating layers of the first and second material in such a way that the reflective element (112, 412) is arranged to operate in the operating frequency of the BAW resonator (100, 300A-C, 402A, 402B).

4. The BAW resonator (100, 300A-C, 402A, 402B) according to any one of the preceding claims, wherein the acoustic impedance modulation layer (116, 302, 404A, 404B) is embedded in a layer of the reflective element (112, 412) adjacent the bottom electrode (106, 414A, 414B).

5. The BAW resonator (100, 300A-C, 402A, 402B) according to any one of the preceding claims, wherein the one or more structures (116A-D, 302A-F, 406A-B) have a thickness in the order of the acoustic wavelength or a fraction of the acoustic wavelength, at the fundamental operating frequency of the BAW resonator (100, 300A-C, 402A, 402B).

6. The BAW resonator (100, 300A-C, 402A, 402B) according to any one of the preceding claims, wherein the acoustic impedance modulation layer (116, 302, 404A, 404B) is arranged so that it extends into two layers of the reflective element (112, 412).

7. The BAW resonator (100, 300A-C, 402A, 402B) according to any one of the preceding claims, wherein the structures (116A-D, 302A-F, 406A-B) are distributed asymmetrically to form the acoustic impedance modulation layer (116, 302, 404A, 404B).

8. The BAW resonator (100, 300A-C, 402A, 402B) according to any one of the preceding claims, further comprising at least one mass load layer (110) on the top electrode (108)

9. The BAW resonator (100, 300A-C, 402A, 402B) according to claim 8, wherein the mass load layer (110) is embedded, or partially embedded in the top electrode (108).

10. An integrated circuit package comprising at least a first and a second BAW resonator (402A; 402B) according to any one of the preceding claims, the first and second BAW resonators (402A; 402B) having different acoustic impedance modulation layers (404A, 404B).

11. The integrated circuit package according to claim 10, comprising a plurality of BAW resonators (100, 300A-C, 402A, 402B) according to any one of the claims 1 - 9 configured in a ladder structure or a lattice structure.

12. A method (500) of manufacturing BAW resonator (100, 300A-C, 402A, 402B) according to any one of the claims 1 - 9, comprising the step of depositing a reflective element (112, 412) on a substrate (102, 408), said reflective element (112, 412) comprising at least a first and a second layer (114B, 418A, 418B) from a first and a second material having a first and second acoustic impedance, respectively, with the second acoustic impedance being different from the first acoustic impedance, placing one or more structures (116A-D, 302A-F, 406A-B) of a third material having a third acoustic impedance different from the first and the second acoustic impedance, in the first and/or the second layer (114B, 418A, 418B), said structures (116A-D, 302A-F, 406A-B) forming an acoustic impedance modulation layer (116, 302, 404A, 404B) within the reflective element (112, 412), **characterized in that** the one or more structures (116A-D, 302A-F, 406A-B) comprise a semiconductor material with a dopant concentration sufficiently large to enable a change in mass density and /or acoustic phase velocity.

13. The method (500) according to claim 12, wherein the step of placing the one or more structures comprises depositing a third layer of the third material on a first or a second layer (114B, 418A, 418B) and etching the third layer to form the structures (116A-D, 302A-F, 406A-B), the method (500) further comprising covering the third layer with a covering layer of the first or the second material and planarizing the covering layer.

14. The method (500) according to claim 12 or 13, wherein the step of placing the one or more structures comprises etching a first or second layer (114B, 418A, 418B) to create spaces for the structures (116A-D, 302A-F, 406A-B), depositing a third layer of the third material and planarizing the third layer.

## Patentansprüche

1. Volumenschallwellen(BAW)resonator (100, 300A-C, 402A, 402B) auf einem Substrat (102, 408), umfassend ein piezoelektrisches Element (104), eine untere Elektrode (106, 414A, 414B) auf einer ersten Fläche (104A) des piezoelektrischen Elements (104) und eine obere Elektrode (108) auf einer zweiten Fläche (104B) des piezoelektrischen Elements (104), die von der ersten Fläche (104A) abgewandt ist, wobei der BAW-Resonator (100, 300A-C, 402A, 402B) ferner ein reflektierendes Element (112, 412) zwischen der unteren Elektrode (106, 414A, 414B) und dem Substrat (102, 408) umfasst, wobei das reflektierende Element (112, 412) mindestens eine erste Schicht (114A, 416A, 416B) eines ersten Materials, das eine erste akustische Impedanz aufweist, und eine zweite Schicht (114B, 418A, 418B) eines zweiten Materials, das eine von der ersten akustischen Impedanz verschiedene zweite akustische Impedanz aufweist, umfasst, wobei die erste oder die zweite Schicht (114A, 416A, 416B, 114B, 418A, 418B) eine oder mehrere Konstruktionen (116A-D, 302A-F, 406A-B) eines dritten Materials, das eine von der ersten und zweiten Impedanz verschiedene dritte akustische Impedanz aufweist, umfasst, wobei die Konstruktionen (116A-D, 302A-F, 406A-B) eine in die erste und/oder die zweite Schicht (114B, 418A, 418B) eingebettete akustische Impedanzmodulationsschicht (116, 302, 404A, 404B) bilden, **dadurch gekennzeichnet, dass** die eine oder mehrere Konstruktionen (116A-D, 302A-F, 406A-B) ein Halbleitermaterial mit einer Dotierungskonzentration umfassen, die groß genug ist, um eine Änderung einer Massendichte und/oder akustischen Phasengeschwindigkeit zu ermöglichen.

2. BAW-Resonator (100, 300A-C, 402A, 402B) nach Anspruch 1, wobei das reflektierende Element (112, 412) eine Bragg-Schicht ist, umfassend eine Vielzahl von verschachtelten ersten und zweiten Schichten (114B, 418A, 418B).

3. BAW-Resonator (100, 300A-C, 402A, 402B) nach Anspruch 1 oder 2, wobei das reflektierende Element (112, 412) aus abwechselnden Schichten des ersten und zweiten Materials auf eine solche Weise zusammengesetzt ist, dass das reflektierende Element (112, 412) angeordnet ist, um bei der Betriebsfrequenz des BAW-Resonators (100, 300A-C, 402A, 402B) betrieben zu werden.

4. BAW-Resonator (100, 300A-C, 402A, 402B) nach einem der vorhergehenden Ansprüche, wobei die akustische Impedanzmodulationsschicht (116, 302, 404A, 404B) in eine mit der unteren Elektrode (106, 414A, 414B) benachbarten Schicht des reflektierenden Elements (112, 412) eingebettet ist.

5. BAW-Resonator (100, 300A-C, 402A, 402B) nach einem der vorhergehenden Ansprüche, wobei die eine oder mehrere Konstruktionen (116A-D, 302A-F, 406A-B) eine Dicke in der Größenordnung der akustischen Wellenlänge oder eines Bruchteils der akustischen Wellenlänge bei der Grundbetriebsfrequenz des BAW-Resonators (100, 300A-C, 402A, 402B) aufweisen.

6. BAW-Resonator (100, 300A-C, 402A, 402B) nach einem der vorhergehenden Ansprüche, wobei die akustische Impedanzmodulationsschicht (116, 302, 404A, 404B) so angeordnet ist, dass sie sich in zwei Schichten des reflektierenden Elements (112, 412) erstreckt.

7. BAW-Resonator (100, 300A-C, 402A, 402B) nach einem der vorhergehenden Ansprüche, wobei die Konstruktionen (116A-D, 302A-F, 406A-B) asymmetrisch verteilt sind, um die akustische Impedanzmodulationsschicht (116, 302, 404A, 404B) zu bilden.

8. BAW-Resonator (100, 300A-C, 402A, 402B) nach einem der vorhergehenden Ansprüche, ferner umfassend mindestens eine Massenbelastungsschicht (110) auf der oberen Elektrode (108).

9. BAW-Resonator (100, 300A-C, 402A, 402B) nach Anspruch 8, wobei die Massenbelastungsschicht (110) in die obere Elektrode (108) eingebettet oder teilweise eingebettet ist.

10. Integriertes Schaltungsgehäuse, umfassend mindestens einen ersten und einen zweiten BAW-Resonator (402A; 402B) nach einem der vorhergehenden Ansprüche, wobei der erste und zweite BAW-Resonator (402A; 402B) unterschiedliche akustische Impedanzmodulationsschichten (404A, 404B) aufweisen.

11. Integriertes Schaltungsgehäuse nach Anspruch 10, umfassend eine Vielzahl von BAW-Resonatoren (100, 300A-C, 402A, 402B) nach einem der Ansprüche 1-9, die in einer Leiterkonstruktion oder einer Gitterkonstruktion konfiguriert sind.

12. Verfahren (500) zum Herstellen eines BAW-Resonators (100, 300A-C, 402A, 402B) nach einem der Ansprüche 1-9, umfassend den Schritt des Aufbringens eines reflektierenden Elements (112, 412) auf ein Substrat (102, 408), wobei das reflektierende Element (112, 412) mindestens eine erste und eine zweite Schicht (114B, 418A, 418B) aus einem ersten und einem zweiten Material, die jeweils eine erste und zweite akustische Impedanz aufweisen, umfasst, wobei die zweite akustische Impedanz von der ersten akustischen Impedanz verschieden ist, des Platzierens einer oder mehrerer Konstruktionen (116A-D, 302A-F, 406A-B) aus einem dritten Material, das eine dritte akustische Impedanz aufweist, die von der ersten und der zweiten akustischen Impedanz verschieden ist, in die erste und/oder die zweite Schicht (114B, 418A, 418B), wobei die Konstruktionen (116A-D, 302A-F, 406A-B) eine akustische Impedanzmodulationsschicht (116, 302, 404A, 404B) innerhalb des reflektierenden Elements (112, 412) bilden, **dadurch gekennzeichnet, dass** die eine oder mehrere Konstruktionen (116A-D, 302A-F, 406A-B) ein Halbleitermaterial mit einer Dotierungskonzentration umfassen, die groß genug ist, um eine Änderung einer Massendichte und/oder akustischen Phasengeschwindigkeit zu ermöglichen.

13. Verfahren (500) nach Anspruch 12, wobei der Schritt des Platzierens der einen oder mehreren Konstruktionen ein Aufbringen einer dritten Schicht des dritten Materials auf einer ersten oder einer zweiten Schicht (114B, 418A, 418B) und ein Ätzen der dritten Schicht, um die Konstruktionen (116A-D, 302A-F, 406A-B) zu bilden, umfasst, wobei das Verfahren (500) ferner ein Abdecken der dritten Schicht mit einer Deckschicht des ersten oder des zweiten Materials und ein Glätten der Deckschicht umfasst.

14. Verfahren (500) nach Anspruch 12 oder 13, wobei der Schritt des Platzierens der einen oder mehreren Konstruktionen ein Ätzen einer ersten oder zweiten Schicht (114B, 418A, 418B), um Zwischenräume für die Konstruktionen (116A-D, 302A-F, 406A-B) zu erzeugen, ein Aufbringen einer dritten Schicht des dritten Materials und ein Glätten der dritten Schicht umfasst.

## Revendications

1. Résonateur à ondes acoustiques de volume, BAW, (100, 300A-C, 402A, 402B) sur un substrat (102, 408), comprenant un élément piézoélectrique (104), une électrode inférieure (106, 414A, 414B) sur une première face (104A) de l'élément piézoélectrique (104) et une électrode supérieure (108) sur une seconde face (104B) de l'élément piézoélectrique (104), opposée à la première face (104A), le résonateur BAW (100, 300A-C, 402A, 402B) comprenant également un élément réfléchissant (112, 412) entre l'électrode inférieure (106, 414A, 414B) et le substrat (102, 408), ledit élément réfléchissant (112, 412) comprenant au moins une première couche (114A, 416A, 416B) d'un premier matériau ayant une première impédance acoustique et une deuxième couche (114B, 418A, 418B) d'un deuxième matériau ayant une deuxième impédance acoustique différente de la première impédance acoustique, dans lequel la première ou la deuxième couche (114A, 416A, 416B, 114B, 418A, 418B) comprend une ou plusieurs structures (116A-D, 302A-F, 406A-B) d'un troisième matériau, ayant une troisième impédance acoustique différente des première et deuxième impédances, lesdites structures (116A-D, 302A-F, 406A-B) formant une couche de modulation d'impédance acoustique (116, 302, 404A, 404B) intégrée dans la première et/ou la deuxième couche (114B, 418A, 418B), **caractérisé en ce que** les une ou plusieurs structures (116A-D, 302A-F, 406A-B) comprennent un matériau semi-conducteur avec une concentration de dopant suffisamment importante pour permettre un changement de densité massique et/ou de vitesse de phase acoustique.

2. Résonateur BAW (100, 300A-C, 402A, 402B) selon la revendication 1, dans lequel l'élément réfléchissant (112, 412) est une couche de Bragg comprenant une pluralité de premières et de deuxièmes couches entrelacées (114B, 418A, 418B).

3. Résonateur BAW (100, 300A-C, 402A, 402B) selon la revendication 1 ou 2, dans lequel l'élément réfléchissant (112, 412) est composé de couches alternées du premier et du deuxième matériau de telle sorte que l'élément réfléchissant (112, 412) est agencé pour fonctionner à la fréquence de fonctionnement du résonateur BAW (100, 300A-C, 402A, 402B).

4. Résonateur BAW (100, 300A-C, 402A, 402B) selon l'une quelconque des revendications précédentes, dans lequel la couche de modulation d'impédance acoustique (116, 302, 404A, 404B) est intégrée dans une couche de l'élément réfléchissant (112, 412) adjacente à l'électrode inférieure (106, 414A, 414B).

5. Résonateur BAW (100, 300A-C, 402A, 402B) selon l'une quelconque des revendications précédentes, dans lequel les une ou plusieurs structures (116A-D, 302A-F, 406A-B) ont une épaisseur de l'ordre de la longueur d'onde acoustique ou d'une fraction de la longueur d'onde acoustique, à la fréquence de fonctionnement fondamentale du résonateur BAW (100, 300A-C, 402A, 402B).

6. Résonateur BAW (100, 300A-C, 402A, 402B) selon l'une quelconque des revendications précédentes, dans lequel la couche de modulation d'impédance acoustique (116, 302, 404A, 404B) est agencée de sorte qu'elle se prolonge sur deux couches de l'élément réfléchissant (112, 412).

7. Résonateur BAW (100, 300A-C, 402A, 402B) selon l'une quelconque des revendications précédentes, dans lequel les structures (116A-D, 302A-F, 406A-B) sont distribuées de manière asymétrique pour former la couche de modulation d'impédance acoustique (116, 302, 404A, 404B).

8. Résonateur BAW (100, 300A-C, 402A, 402B) selon l'une quelconque des revendications précédentes, comprenant également au moins une couche de charge de masse (110) sur l'électrode supérieure (108).

9. Résonateur BAW (100, 300A-C, 402A, 402B) selon la revendication 8, dans lequel la couche de charge de masse (110) est intégrée, ou partiellement intégrée dans l'électrode supérieure (108).

10. Boîtier de circuit intégré comprenant au moins un premier et un second résonateur BAW (402A ; 402B) selon l'une quelconque des revendications précédentes, les premier et second résonateurs BAW (402A ; 402B) ayant différentes couches de modulation d'impédance acoustique (404A, 404B).

11. Boîtier de circuit intégré selon la revendication 10, comprenant une pluralité de résonateurs BAW (100, 300A-C, 402A, 402B) selon l'une quelconque des revendications 1 à 9 configurés dans une structure en échelle ou une structure en treillis.

12. Procédé (500) de fabrication d'un résonateur BAW (100, 300A-C, 402A, 402B) selon l'une quelconque des revendications 1 à 9, comprenant l'étape de dépôt d'un élément réfléchissant (112, 412) sur un substrat (102, 408), ledit élément réfléchissant (112, 412) comprenant au moins une première et une deuxième couche (114B, 418A, 418B) constituées d'un premier et d'un deuxième matériau ayant respectivement une première et une deuxième impédance acoustique, la deuxième impédance acoustique étant différente de la première impédance acoustique, de placement d'une ou plusieurs structures (116A-D, 302A-F, 406A-B) constituées d'un troisième matériau ayant une troisième impédance acoustique différente des première et deuxième impédances acoustiques, dans la première et/ou la deuxième couche (114B, 418A, 418B), lesdites structures (116A-D, 302A-F, 406A-B) formant une couche de modulation d'impédance acoustique (116, 302, 404A, 404B) à l'intérieur de l'élément réfléchissant (112, 412), **caractérisé en ce que** les une ou plusieurs structures (116A-D, 302A-F, 406A-B) comprennent un matériau semi-conducteur avec une concentration de dopant suffisamment importante pour permettre un changement de densité massique et/ou de vitesse de phase acoustique.

13. Procédé (500) selon la revendication 12, dans lequel l'étape de placement des une ou plusieurs structures comprend le dépôt d'une troisième couche du troisième matériau sur une première ou une deuxième couche (114B, 418A, 418B) et la gravure de la troisième couche pour former les structures (116A-D, 302A-F, 406A-B), le procédé (500) comprenant également le recouvrement de la troisième couche par une couche de recouvrement du premier ou du deuxième matériau et la planarisation de la couche de recouvrement.

14. Procédé (500) selon la revendication 12 ou 13, dans lequel l'étape de placement des une ou plusieurs structures comprend la gravure d'une première ou d'une deuxième couche (114B, 418A, 418B) pour créer des espaces pour les structures (116A-D, 302A-F, 406A-B), le dépôt d'une troisième couche du troisième matériau et la planarisation de la troisième couche.
